# EUROPEAN PATENT APPLICATION

(11) **EP 3 392 593 A1**
(43) Date of publication of application: **24.10.2018**
(21) Application number: 16875793.8
(22) Date of filing: 16.12.2016
(51) Int. Cl.: F28D 15/02, F28D 15/04

(54) **VAPOR CHAMBER**

(30) Priority: 18.12.2015 JP 2015247804
(71) Applicant: Fujikura Ltd., Tokyo 135-8512 (JP)
(72) Inventor: PHAN Thanhlong, Tokyo 135-8512 (JP); YOKOYAMA Yuichi, Tokyo 135-8512 (JP); KAWAHARA Youji, Tokyo 135-8512 (JP); SAITO Yuji, Tokyo 135-8512 (JP); AHAMED Mohammad Shahed, Tokyo 135-8512 (JP); MASHIKO Koichi, Tokyo 135-8512 (JP); MOCHIZUKI Masataka, Tokyo 135-8512 (JP)
(74) Representative: Cabinet Plasseraud
(86) International application number: PCT/JP2016/087602
(87) International publication number: WO 2017/104819

(57) **Abstract**

A vapor chamber includes an upper plate, a lower plate, side walls, a wick body, and a pillar that comes into contact with the upper plate and the lower plate. The wick body includes a plurality of first wick portions each of which extends to the side walls from a first terminal thereof positioned in a vaporization portion and includes a linear portion, and a second wick portion that connects second terminals of the first wick portions to each other, and the pillar is disposed between the linear portions of two adjacent first wick portions among the first wick portions such that the pillar is positioned away from the linear portions.

## Description

### TECHNICAL FIELD

The present invention relates to a vapor chamber.

Priority is claimed on Japanese Patent Application No. 2015-247804, filed on December 18, 2015, the content of which is incorporated herein by reference.

### BACKGROUND ART

A vapor chamber is generally a rectangular flat plate-shaped device and is one type of a heat pipe in which heat can be efficiently transferred in an in-plane direction. A vapor chamber in the related art includes a hollow container that is sealed with an upper member and a lower member and a working fluid is in the container. In the vapor chamber, a portion that functions as a vaporization portion and a portion that functions as a condensation portion are present. When the vaporization portion is heated by a heat source, vaporization of the working fluid in the container occurs and the working fluid in a gas phase moves to a low-temperature region (condensation portion) in the container. In the low-temperature region, the working fluid in the gas phase is cooled and condensed. Accordingly, heat received by the working fluid at the vaporization portion is released to the outside of the vapor chamber. The condensed working fluid returns to the vaporization portion via a wick provided in the container due to a capillary action. The working fluid having returned to the vaporization portion is vaporized again and moves to the low-temperature region. As described above, in the vapor chamber, heat is transferred by using latent heat through repetitive vaporization and condensation of the working fluid.

The vapor chamber is used for cooling an electronic device or the like, for example. Recently, the electronic device becomes thinner and thinner. Therefore, there is a limit on the structure of the electronic device. For example, in a portable electronic device typified by a smartphone, a plurality of electronic components are accommodated in a limited space. A graphite sheet or a heat pipe having a high thermal conductivity is used in order to dissipate heat that is generated from a processor or the like in the limited space.

In addition, a sheet type heat pipe, which is obtained by stacking and bonding two or more metal foil sheets obtained through etching processing or pressing processing to form a sealed container and forming fine uneven portions on an inner surface of the container such that heat is transferred, has also been proposed (refer to PTL 1).

### PRIOR ART DOCUMENTS

[PTL 1] Japanese Unexamined Patent Application, First Publication No. 2015-121355

### DISCLOSURE OF INVENTION

### PROBLEMS TO BE SOLVED BY THE INVENTION

However, in recent years, there is a demand for heat transferring means that has a thinner structure and with which it is possible to secure the heat transferring efficiency.

One of the reasons for this is as follows. In the case of a portable electronic device for which the above-described graphite sheet or the heat pipe is used, a CPU (semiconductor element) used for the electronic component is maintained at a very high temperature (for example, temperature equal to or greater than 80°C). The semiconductor element cannot tolerate such a temperature in some cases.

A general graphite sheet has a high in-plane thermal conductivity but has a relatively poor thermal conductivity in a thickness direction. Therefore, transfer of heat performed by the general graphite sheet is effective for a small-sized low-output CPU, for example. However, when the general graphite sheet is used for a high-output CPU, the temperature of the CPU cannot be sufficiently suppressed in some cases.

The heat pipe is ideal heat transferring means that can transfer heat without generating a large temperature difference between a first end and a second end. However, for a small-sized portable electronic device such as a smartphone, a very small and thin heat pipe is needed. With the small and thin heat pipe, it may not be possible to secure a sufficient heat transferring efficiency and to suppress the temperature of the CPU within a desired range.

In the sheet type heat pipe in PTL 1, grooves, each of which serves as a flow path through which a hydraulic fluid condensed in a dissipation portion returns to a heat receiving portion, are formed through etching processing. Therefore, a capillary force becomes insufficient and it is difficult to improve the heat transferring efficiency. In addition, only grooves in a peripheral portion are in contact with the vaporization portion, and thus the hydraulic fluid does not efficiently return in some cases.

In addition, the thickness of the vapor chamber in the related art is 3 mm to several cm. However, for a portable electronic device such as a smartphone, heat transferring means of which the thickness is 0.3 to 0.8 mm or thinner heat transferring means is required. Therefore, with the vapor chamber in the related art, it may not be possible to cope with a required thinness although the heat transferring efficiency is sufficient.

The present invention has been made in consideration of the above-described problems and an object thereof is to provide a vapor chamber with which it is possible to secure a favorable heat transferring efficiency even when the thickness thereof is reduced.

### MEANS FOR SOLVING THE PROBLEMS

A vapor chamber according to a first aspect of the invention includes an upper plate, a lower plate, a plurality of side walls disposed between the upper plate and the lower plate, a wick body that is disposed in a space sealed by the upper plate, the lower plate, and the side walls and that comes into contact with the upper plate and the lower plate, and a pillar that is disposed in the space and comes into contact with the upper plate and the lower plate. The wick body includes a plurality of first wick portions each of which extends to the side walls from a first terminal thereof positioned in a vaporization portion and includes a linear portion, and a second wick portion that connects second terminals of the first wick portions to each other, and the pillar is disposed between the linear portions of two adjacent first wick portions among the first wick portions such that the pillar is positioned away from the linear portions.

According to the vapor chamber in the aspect, the first wick portions include the linear portions and the pillar is positioned between the linear portions such that a flow path of a gas-phase working fluid extends straight up to a low-temperature region positioned away from the vaporization portion. Accordingly, the heat transferring efficiency can be increased since a flow path, through which a gas-phase working fluid proceeds toward the low-temperature region from the vaporization portion, is shortened and the gas-phase working fluid quickly moves to the low-temperature region.

Here, at least a portion of a facing surface of the pillar that faces the linear portions may extend to be parallel to the linear portions.

In this case, the section of a flow path between the pillar and the linear portions becomes uniform along the linear portions. Therefore, the flow of the gas-phase working fluid in the flow path becomes stable and thus it is possible to further increase the heat transferring efficiency.

### EFFECTS OF THE INVENTION

According to the aspect, it is possible to provide a vapor chamber with which it is possible to secure a heat transferring efficiency even when the thickness thereof is reduced.

### BRIEF DESCRIPTION OF DRAWINGS

FIG. 1 is a perspective view illustrating the appearance of a vapor chamber according to a first embodiment.
FIG. 2 is a sectional view of the vapor chamber in the FIG. 1 as seen in a direction along arrow II-II.
FIG. 3 is a sectional view of the vapor chamber in the FIG. 1 as seen in a direction along arrow III-III.
FIG. 4 is a schematic view illustrating an internal configuration of a vapor chamber according to a second embodiment.
FIG. 5 is a sectional view schematically illustrating the appearance of a vapor chamber according to a third embodiment.

### EMBODIMENTS FOR CARRYING OUT THE INVENTION

### (First Embodiment)

Hereinafter, a vapor chamber according to a first embodiment will be described with reference to drawings. In the drawings, a proportion between constituent elements may not be the same as the actual proportion.

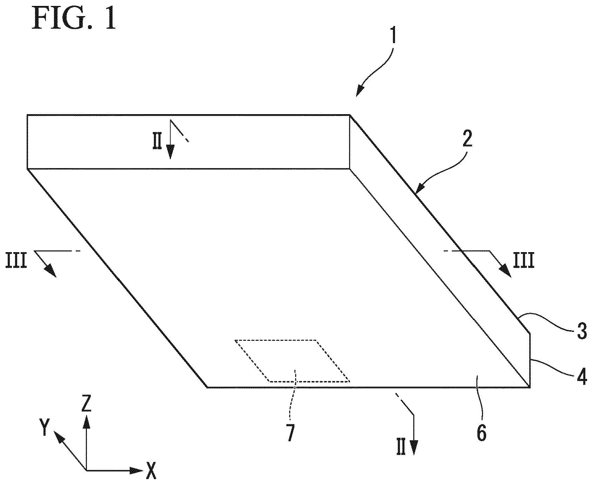

FIG. 1 is a perspective view illustrating an example of the appearance of a vapor chamber 1 according to the present embodiment. The vapor chamber 1 includes a hollow flat plate-shaped container 2 that is sealed. The inside of the container 2 is filled with a working fluid in a state where a non-condensable gas such as air is extracted.

As illustrated in FIGS. 1 to 3, the container 2 includes an upper plate 3, a lower plate 6, and side walls 4. Here, in the present embodiment, a positional relationship between the components will be described with an XYZ rectangular coordinate system being set. A Z axis direction (up-down direction) is a direction in which the upper plate 3 and the lower plate 6 face each other.

Each of the upper plate 3 and the lower plate 6 is formed to have a flat rectangular (rectangle) plate-like shape of which the length in a Y axis direction is larger than that in an X axis direction. Each of the upper plate 3 and the lower plate 6 extends within a plane that is parallel to the X axis and the Y axis. The side walls 4 are integrally formed with the lower plate 6 and extend in the Z axis direction from an outer peripheral edge of the lower plate 6 to an outer peripheral edge of the upper plate 3. Note that, the side walls 4 may be separated from the lower plate 6. The upper plate 3 and the side walls 4 are bonded to each other via sintering or a bonding agent. Note that, the upper plate 3 and the side walls 4 may be bonded to each other by using another method.

The side walls 4 are formed to have a rectangular frame-like shape that includes a first side wall 4a, a second side wall 4b, a third side wall 4c, and a fourth side wall 4d. The first side wall 4a and the second side wall 4b are positioned at positions corresponding to short sides of the rectangular shape and face each other. The first side wall 4a and the second side wall 4b extend to be parallel to the X axis. The third side wall 4c and the fourth side wall 4d are positioned at positions corresponding to long sides of the rectangular shape and face each other. The third side wall 4c and the fourth side wall 4d extend to be parallel to the Y axis.

The upper plate 3, the side wall 4, and the lower plate 6 may be formed of copper which has a high thermal conductivity. Alternatively, the strength and the thermal conductivity may be achieved at the same time by combining stainless steel and copper.

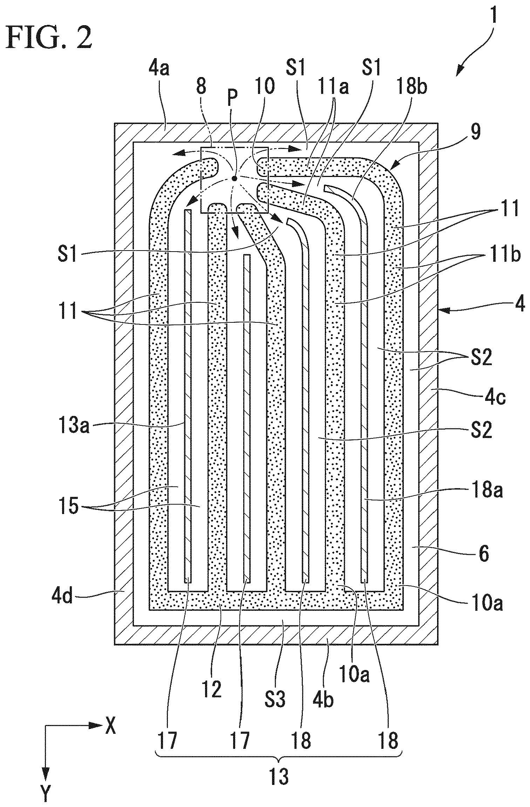

On a lower surface of the lower plate 6, a heat source 7 such as an electronic component is disposed such that heat can be transferred to the lower plate 6. The heat source 7 may be bonded to the lower surface of the lower plate 6, for example. Alternatively, the heat source 7 may be in contact with or may be close to the lower surface of the lower plate 6. A portion of a space in the container 2 that is in the vicinity of the heat source 7 and is heated by the heat source 7 is a portion that corresponds to a vaporization portion at which working fluid is vaporized. Hereinafter, a portion of the space in the container 2 that corresponds to the vaporization portion will be simply referred to as a vaporization portion 8 (refer to FIG. 2). The vaporization portion 8 is disposed in the vicinity of the first side wall 4a. In addition, a portion of the space in the container 2 that is away from the vaporization portion 8 is a low-temperature region at which the working fluid is condensed. Note that, in FIG. 2, the second side wall 4b is significantly separated from the vaporization portion 8 and thus the temperature of the vicinity of the second side wall 4b becomes relatively low. Accordingly, the working fluid is efficiently condensed in the vicinity of the second side wall 4b.

As illustrated in FIG. 2, in the container 2, a wick body 9 and a plurality of pillars 13 are provided.

The wick body 9 includes a plurality of wicks 11 (first wick portions). A first terminal 10 of each of the plurality of wicks 11 is disposed at a position corresponding to the vaporization portion 8 within the space in the container 2. More specifically, the first terminals 10 are disposed to surround a point P that is on the center of the vaporization portion 8 and each first terminal 10 is disposed such that an interval in the Y axis direction or the X axis direction is provided between each first terminal 10 and the point P. Accordingly, the wicks 11 come into thermal contact with the heat source 7. In the present embodiment, the heat source 7 and the vaporization portion 8 are disposed in the vicinity of the first side wall 4a. The plurality of elongated wicks 11 extend from the vaporization portion 8 toward the second side wall 4b that faces the first side wall 4a. In Fig. 2, five wicks 11 are provided.

At least a portion of the plurality of wicks 11 includes a radial portion 11a that radially extends from the vaporization portion 8 and a linear portion 11b that linearly extends from an end portion of the radial portion 11a. In FIG. 2, each linear portion 11b extends straight toward the second side wall 4b that is significantly separated from the vaporization portion 8. Each linear portion 11b extends to be parallel to the Y axis (to be parallel to the third side wall 4c and the fourth side wall 4d). Note that, for example, in a case where the third side wall 4c and the fourth side wall 4d are not parallel to the Y axis, each linear portion 11b may not extend to be parallel to the third side wall 4c and the fourth side wall 4d. Even in this case, it is possible to shorten a flowing route of a gas-phase working fluid toward the second side wall 4b by forming each linear portion 11b into a linear shape extending toward the second side wall 4b.

The wick body 9 further includes a connection wick 12 (second wick portion) that connects second terminals 10a (terminals that are opposite to first terminals 10) of the plurality of wicks 11 to each other. The connection wick 12 is disposed to be approximately parallel to the second side wall 4b with a gap provided therebetween. Since the wicks 11 are connected to each other by the connection wick 12, the wick body 9 has a continuous structure except in the vaporization portion 8.

Examples of the material of the wick body 9 include a metal ultrafine wire fiber, a metal mesh, a sintered body of metal powder, or a wick manufactured through etching. A working fluid in a liquid phase can move via the wick body 9 due to a capillary action. The wick body 9 is fixed to the upper plate 3 and the lower plate 6 through sintering.

Each pillar 13 is disposed on the approximately center of a space between adjacent two wicks 11. An interval between the wick 11 and the pillar 13 may be, for example, 3 mm or more. The pillars 13 are formed to have a plate-like shape of which the thickness in the X axis direction is small. The pillars 13 extend in the Z axis direction between the upper plate 3 and the lower plate 6. The plurality of pillars 13 are arranged at intervals in the X axis direction. At least a portion of the pillars 13 extends along the Y axis. More specifically, at least a portion of a facing surface 13a of each pillar 13 that faces the linear portion 11b of each wick 11 extends to be parallel to the linear portion 11b. Note that, the radial portion 11a of each wick 11 is disposed in the vicinity of the vaporization portion 8 and an interval between the radial portions 11a becomes larger as the distance from the point P increases. An end portion of each pillar 13 that is on the vaporization portion 8 side is positioned in a portion where an interval between the radial portions 11a becomes somewhat large (for example, 6 mm or more). Therefore, the width of a flow path through which a gas-phase working fluid flows is secured.

In FIG. 2, no pillar 13 is disposed between the first terminals 10. However, the invention is not limited to this and for example, intervals between the first terminals 10 may be enlarged and the pillars 13 may extend up to positions between the first terminals 10.

In FIG. 2, in a space sealed by the upper plate 3, the lower plate 6 and the side walls 4, the plurality of pillars 13 that extend from the vaporization portion 8 to the second side wall 4b are disposed. The plurality of pillars 13 include at least a first pillar 17 and a second pillar 18.

First pillars 17 linearly extend along the linear portions 11b of the wicks 11.

Second pillars 18 include parallel portions 18a that linearly extend along the linear portions 11b and curved portions 18b that are curved. The curved portions 18b are disposed closer to the vaporization portion 8 than the parallel portions 18a and are connected to the parallel portions 18a. Therefore, the second pillars 18 linearly extend along the linear portions 11b and end portions thereof that are close to the vaporization portion 8 are curved. The curved portions 18b are curved in a direction toward the point P on the center of the vaporization portion 8 from the parallel portions 18a.

The curved portions 18b are disposed such that the width of radial flow paths S1, which will be described later, becomes as equal as possible to the width of linear flow paths S2. Therefore, a gas-phase working fluid can flow into two radial flow paths S2 that branch off from each other due to the curved portion 18b without uneven distribution. Therefore, a gas-phase working fluid can equally flow into two adjacent linear flow paths S2 with the parallel portion 18a interposed therebetween.

The pillars 13 are fixed to the upper plate 3 and the lower plate 6 through brazing or the like. The material of the pillars 13 is preferably metal or the like through which air or steam cannot pass and which has a favorable thermal conductivity. For example, the pillars 13 may be formed of copper or the like.

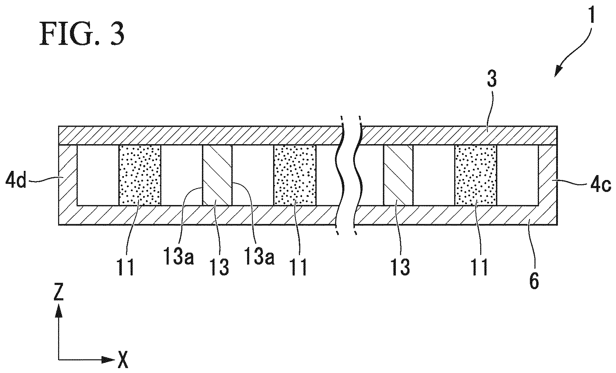

Note that, in FIG. 3, the pillars 13 are separated from the upper plate 3 and the lower plate 6. However, the invention is not limited to this and the pillars 13 may be integrally formed with the upper plate 3 or the lower plate 6. In the present embodiment, four pillars are provided. However, the invention is not limited to this as long as at least one pillar is disposed between the wicks 11.

According to the above-described configuration, in the container 2, the radial flow paths S1 that radially extend from the vaporization portion 8, the linear flow paths S2 that extend in the Y axis direction, and a connection flow path S3 that extends in the X axis direction in the vicinity of the second side wall 4b are formed. A gas-phase working fluid that is vaporized at the vaporization portion 8 flows in the flow paths S1, S2 and S3. Hereinafter, the flow paths S1, S2 and S3 will be described in detail.

Each radial flow path S1 is formed between the radial portions 11a of the plurality of wicks 11. In addition, the radial flow path S1 is also formed between the first side wall 4a and a portion of the radial portions 11a.

The plurality of linear flow paths S2 are arranged at intervals in the X axis direction. Each linear flow path S2 is connected to an end portion of the radial flow path S1 that is on a side opposite to the vaporization portion 8 side. The linear flow paths S2 are formed between the third side wall 4c and the linear portion 11b, between the linear portions 11b and the pillars 13, and between the linear portion 11b and the fourth side wall 4d, respectively.

Here, each pillar 13 is disposed at least in a position between the linear portions 11b of the adjacent wicks 11 such that intervals between the linear portions 11b and the pillars 13 become equal. Therefore, the flow path sectional areas of two linear flow paths S2 that are positioned on both sides of the pillar 13 in the X axis direction are equal to each other. In addition, at least a portion of the facing surface 13a of each pillar 13 that faces the linear portion 11b extends to be parallel to the linear portion 11b. Therefore, the section of the linear flow path S2 positioned between the pillar 13 and the linear portion 11b is uniform in a direction in which the linear portion 11b extends (Y axis direction).

The connection flow path S3 is formed between the connection wick 12 and the second side wall 4b. The connection flow path S3 connects the linear flow path S2 between the third side wall 4c and the wick 11 and the linear flow path S2 between the fourth side wall 4d and the wick 11 to each other.

Next, the operation of the vapor chamber 1 configured as described above will be described.

When the working fluid in the vaporization portion 8 is vaporized due to heat from the heat source 7, a gas-phase working fluid flows into the plurality of radial flow paths S1 in a diffusing manner. In FIG. 2, the flow of the gas-phase working fluid vaporized at the vaporization portion 8 is represented by arrows. The gas-phase working fluid flowing into each radial flow path S1 flows into each linear flow path S2. In the linear flow path S2, movement of the gas-phase working fluid in the X axis direction is restricted. Therefore, the gas-phase working fluid flows straight in the Y axis direction toward the second side wall 4b inside the linear flow path S2. Then, as the distance from the vaporization portion 8 increases, the gas-phase working fluid is cooled and condensed. The condensation phenomenon occurs particularly frequently in the vicinity of the second side wall 4b that is significantly separated from the vaporization portion 8.

When the working fluid is condensed, the liquid-phase working fluid returns to the vicinity of the first terminals 10 of the wicks 11 via the connection wick 12 and the wicks 11. The liquid-phase working fluid having returned to the vicinity of the first terminals 10 receives heat from the heat source 7 and is vaporized from surfaces of the wicks 11 again. As described above, in the vapor chamber 1, heat recovered from the vaporization portion 8 can be repeatedly transferred to a cooling region (condensation portion) by using latent heat through repetitive phase transition between a liquid phase and a gas phase of the working fluid.

Note that, in the present embodiment, the plurality of radial flow paths S1 and the plurality of linear flow paths S2 that are respectively connected to the radial flow paths S1 are formed. However, the gas-phase working fluid can efficiently reach the vicinity of the second side wall 4b through any flow path. Therefore, it is possible to cause the gas-phase working fluid to quickly flow to the vicinity of the second side wall 4b that is significantly separated from the vaporization portion 8 and thus it is possible to efficiently condense the gas-phase working fluid in the vicinity of the second side wall 4b. Furthermore, since the gas-phase working fluid is caused to quickly flow as described above, it is possible to prevent the working fluid from being condensed before reaching the vicinity of the second side wall 4b and to smoothly circulate the working fluid within a wide range inside the vapor chamber 1. According to this configuration, it is possible to maintain uniform distribution of the working fluid in the vapor chamber 1 and to efficiently diffuse heat.

As described above, the pillars 13 have a function of improving a flowing efficiency of the gas-phase working fluid in the Y axis direction from the vaporization portion 8 to the second side wall 4b. Furthermore, the pillars 13 also have a function of improving the hardness of the entire vapor chamber 1 by connecting the upper plate 3 and the lower plate 6 inside the container 2. Accordingly, it is possible to suppress deformation of the vapor chamber 1 which is caused by thermal expansion of the container 2 or the upper plate 3 and the lower plate 6 being depressed by an external force. Note that, if the pillars 13 can exhibit these functions, the pillars 13 may not be disposed such that distances between the wicks 11 and the pillars 13 become equal as long as the pillars 13 are disposed to be away from the wicks 11.

As described above, according to the vapor chamber 1 in the present embodiment, the plurality of first wick portions 11 include the linear portions 11b and the pillars 13 are positioned between the linear portions 11b such that the plurality of linear flow paths S2 are formed. Accordingly, the heat transferring efficiency can be increased since a flow path, through which the gas-phase working fluid proceeds toward the vicinity of the second side wall 4b positioned away from the vaporization portion 8, is shortened and the gas-phase working fluid is quickly condensed.

In addition, since the heat transferring efficiency is improved in this manner, even if the thickness of the vapor chamber 1 is reduced, it is possible to sufficiently dissipate heat of the heat source 7. Therefore, it is possible to obtain the vapor chamber 1 that can be incorporated into a thin portable electronic device such as a smartphone and that has a thickness of about 0.4 mm.

Note that, for example, in the case of the thin vapor chamber 1 having a thickness of 0.4 mm in the Z axis direction, if a flow path between the pillar 13 and the wick 11 is excessively narrow, steam pressure loss becomes greater than the capillary pressure, the liquid-phase working fluid is inhibited from flowing, and the maximum heat transferring amount in the vapor chamber becomes small. Therefore, in the present embodiment, an interval between the wick 11 and the pillar 13 is set to be, for example, 3 mm or more. In this manner, the flow path sectional areas of the linear flow paths S2 are sufficiently enlarged such that the steam pressure loss is reduced enough and the gas-phase working fluid can easily flow.

In addition, since at least a portion of the facing surface 13a of each pillar 13 that faces the linear portion 11b extends to be parallel to the linear portion 11b, the section of the linear flow path S2 positioned between the pillar 13 and the linear portion 11b is uniform along the linear portion 11b. Therefore, the flow of the gas-phase working fluid in the linear flow paths S2 becomes stable and thus it is possible to more reliably increase the heat transferring efficiency.

### (Second Embodiment)

In the first embodiment, a configuration example that is preferable in a case where the heat source 7 and the vaporization portion 8 are provided in the vicinity of the first side wall 4a has been described. However, the configurations of the wick bodies and the pillars may be appropriately modified in accordance with the positions of the heat source 7 and the vaporization portion 8.

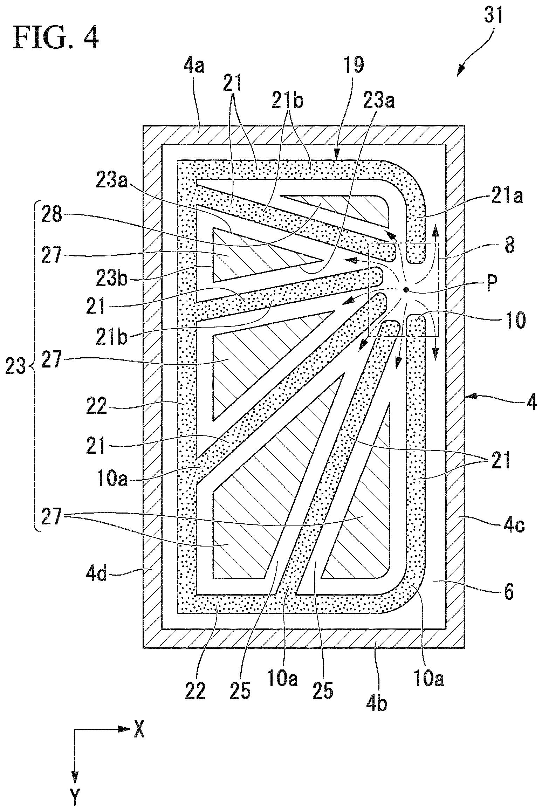

For example, a vapor chamber 31 according to another embodiment is illustrated in FIG. 4. In the drawing, the member described in the above-described embodiment is given the same reference symbol and description thereof will be omitted. In the drawing, a proportion between constituent elements may not be the same as the actual proportion

In the vapor chamber 31, the vaporization portion 8 is provided in the vicinity of the third side wall 4c. A plurality of elongated wicks 21 (first wick portions) of a wick body 19 in FIG. 4 radially extend from the vaporization portion 8. The first terminal 10 of each of the wicks 21 is positioned in the vaporization portion 8. More specifically, the first terminals 10 are disposed to surround the point P that is on the center of the vaporization portion 8 and each first terminal 10 is disposed such that an interval in the Y axis direction or the X axis direction is provided between each first terminal 10 and the point P. Each wick 21 includes a linear portion 21b that linearly extends toward the second side wall 4b or the fourth side wall 4d. A portion of the wicks 21 includes a radial portion 21a that radially extends from the vaporization portion 8 in addition to the linear portion 21b. In addition, the linear portions 21b of the other wicks 21 radially extend from the vaporization portion 8.

The wick body 19 further includes a connection wick 22 (second wick portion) that connects the second terminals 10a of the plurality of wicks 21 to each other. The connection wick 22 is formed to have an L-like shape that extends along the second side wall 4b and the fourth side wall 4d. Since the wicks 21 are connected to each other by the connection wick 22, the wick body 19 has a continuous structure except in the vaporization portion 8.

A connection portion between the radial portion 21a and the linear portion 21b and a connection portion between at least a portion of the linear portions 21b and the connection wick 22 are curved.

Each of pillars 23 is disposed between two adjacent wicks 21 such that intervals between the wicks 21 and the pillars 23 become equal. Each of the intervals is, for example, an interval of 3 mm or more. In the container 2, the plurality of pillars 23 are disposed. A portion of the plurality of pillars 23 is disposed in a space between adjacent wicks 21. Each of the other pillars 23 is disposed in a space surrounded by adjacent wicks 21 and the connection wick 22 that connects the second terminals 10a thereof. These spaces and the pillars 23 positioned in the spaces have approximately similar shapes. For example, in a case where the space surrounded by the adjacent wicks 21 and the connection wick 22 that connects the wicks 21 has a triangular shape (polygonal shape), the pillar 23 positioned in the space is formed to have a triangular shape (polygonal shape) that is approximately similar to the shape of the space. The pillar 23 is disposed in the approximately central portion in the space.

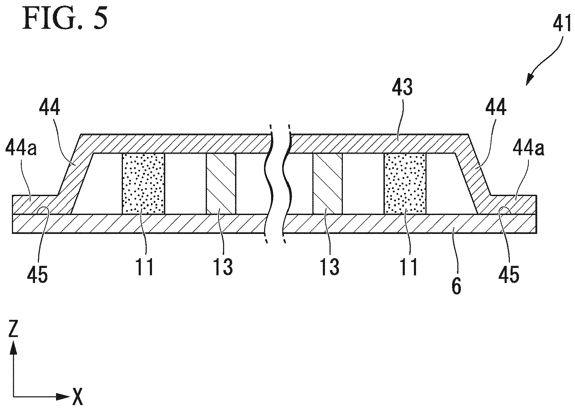

In FIG. 5, in a space sealed by the upper plate 3, the lower plate 6 and the side walls 4, the plurality of pillars 23 that extend from the vaporization portion 8 to the second side wall 4b or the fourth side wall 4d are disposed. The plurality of pillars 23 include at least a third pillar 27 and a fourth pillar 28.

Each of the third pillars 27 is formed to have a spreading-out shape in which the width of an end portion close to the second side wall 4b or the fourth side wall 4d is larger than the width of an end portion close to the vaporization portion 8. The width of each third pillar 27 increases as the distance from the vaporization portion 8 increases. The vapor chamber 31 illustrated in FIG. 5 is provided with the plurality of third pillars 27. The width of at least a portion of the third pillars 27 increases as the distance from the vaporization portion 8 increases up to a predetermined position and the width thereof decreases again as the distance from the vaporization portion 8 increases in an area beyond the predetermined position.

The fourth pillar 28 is formed to have a tapered shape in which the width of an end portion close to the fourth side wall 4d is smaller than the width of an end portion close to the vaporization portion 8. The width of the fourth pillar 28 decreases as the distance from the vaporization portion 8 increases.

A portion of the third pillars 27 and the fourth pillar 28 described above has a polygonal shape of which at least one corner is round. Each round corner portion faces the curved connection portion between the radial portion 21a and the linear portion 21b or the curved connection portion between the linear portion 21b and the connection wick 22. Therefore, the width of a gas phase paths 25 between the round corner portion of the third pillar 27 or the fourth pillar 28 and the wick body 19 and the widths of the other gas phase paths 25 are approximately constant.

Note that, the size of an interval between the wicks 21 increases as the distance from the point P increases. An end portion of each pillar 23 that is in the vicinity of the vaporization portion 8 is positioned in a portion where an interval between the wicks 21 becomes somewhat large (for example, 6 mm or more). Therefore, the width of a flow path through which a gas-phase working fluid flows is secured.

In addition, a facing surface 23a of each pillar 23 that faces the linear portion 21b of the wick 21 extends to be parallel to the linear portion 21b. Similarly, a facing surface 23b of each pillar 23 that faces the connection wick 22 extends to be parallel to the connection wick 22. Therefore, the gas phase paths 25 of which the width is approximately constant are formed around the pillars 23. Through the gas phase paths 25, the gas-phase working fluid flows.

Here, it is also possible to conceive to suppress the steam pressure loss by using linear pillars similar to those in the first embodiment such that the widths of the gas phase paths 25 increase as the distance from the vaporization portion 8 increases. However, in this case, the flowing speed of the gas-phase working fluid decreases as the distance from the vaporization portion 8 increases or the gas-phase working fluid becomes likely to flow in a width direction within the gas phase paths 25. As a result, the gas-phase working fluid becomes likely to be condensed before reaching the vicinity of the second side wall 4b or the fourth side wall 4d.

With regard to this, in the present embodiment, the shapes of the pillars 23 are devised such that the gas phase paths 25 extend straight toward the second side wall 4b or the fourth side wall 4d and the widths of the gas phase paths 25 become approximately constant. Therefore, it is possible to cause the gas-phase working fluid to quickly flow to the vicinity of the second side wall 4b or the fourth side wall 4d significantly separated from the vaporization portion 8 and thus it is possible to efficiently condense the gas-phase working fluid in the vicinity of the side walls 4b and 4d. Furthermore, since the gas-phase working fluid is caused to quickly flow as described above, it is possible to prevent the working fluid from being condensed before reaching the vicinity of the second side wall 4b or the fourth side wall 4d and to smoothly circulate the working fluid within a wide range inside the vapor chamber 31.

Note that, the number of the wicks 21 or the like may be appropriately changed. In addition, the pillars 23 may not be disposed in equal distance from the wicks 21 or the connection wick 22 as long as the pillars 23 are disposed away from the wicks 21 and 22.

### (Third Embodiment)

In the first and second embodiments, the vapor chambers 1 and 31 in which the upper plate 3 and the lower plate 6, which are rectangular flat plates, are bonded to each other via the side walls 4 have been described. However, the shape of the vapor chamber is not limited to those in the above-described embodiments and the shape of the vapor chamber can be modified in various ways in accordance with the shape of a thin portable electronic device into which the vapor chamber is incorporated.

For example, a vapor chamber 41 having a section as illustrated in FIG. 5 may also be adopted.

An internal configuration of the vapor chamber 41 is the same as that of the vapor chamber 1 in the above-described embodiment except for the shape of side walls. Side walls 44 in the present embodiment include protruding portions 44a that protrude toward the outside of the vapor chamber. The side walls 44 and an upper plate 43 are integrally formed with each other and form a shape that protrudes upward. In FIG. 5, the side walls 44 are inclined with respect to the lower plate 6. However, the side walls 44 may be formed to be perpendicular to the lower plate 6. The protruding portions 44a are bonded to edge portions 45 of the lower plate 6 through brazing such that a container of the vapor chamber 41 is formed. Note that, in addition to the upper plate 3, the lower plate 6 may also have a protruding shape similar to that of the upper plate 3.

Hereinabove, the preferable embodiments have been described. However, the embodiments are examples of the invention and are not intended to limit the invention. Addition, omission, substitution, and other modifications can be made without departing from the scope of the invention. The invention is not limited by the foregoing description, but is limited by the claims.

### DESCRIPTION OF THE REFERENCE SYMBOLS

1, 31, 41...vapor chamber 3, 43...upper plate 4, 44...side wall 6...lower plate 8...vaporization portion 9, 19...wick body 10...first terminal 10 a...second terminal 11, 21...wick (first wick portion) 11b, 21b...linear portion 12, 22...connection wick (second wick portion) 13, 23...pillar 13a, 23a...facing surface 17...first pillar 18...second pillar 27...third pillar 28...fourth pillar S1...radial flow path S2...linear flow path S3...connection flow path

## Claims

1. A vapor chamber comprising:
an upper plate;
a lower plate;
a plurality of side walls disposed between the upper plate and the lower plate;
a wick body that is disposed in a space sealed by the upper plate, the lower plate, and the side walls and that comes into contact with the upper plate and the lower plate; and
a pillar that is disposed in the space and comes into contact with the upper plate and the lower plate,
wherein the wick body includes
a plurality of first wick portions each of which extends to the side walls from a first terminal thereof positioned in a vaporization portion and includes a linear portion, and
a second wick portion that connects second terminals of the first wick portions to each other, and
wherein the pillar is disposed between the linear portions of two adjacent first wick portions among the first wick portions such that the pillar is positioned away from the linear portions.

2. The vapor chamber according to claim 1,
wherein at least a portion of a facing surface of the pillar that faces the linear portions extends to be parallel to the linear portions.

3. The vapor chamber according to claims 1 or 2,
wherein a plurality of pillars including the pillar are disposed in the space, and
wherein the pillars include at least a first pillar that has a linear shape extending along the linear portions and a second pillar that linearly extends along the linear portions and of which an end portion close to the vaporization portion is curved.

4. The vapor chamber according to claims 1 or 2,
wherein a plurality of pillars including the pillar and extending from the vaporization portion to the side walls are disposed in the space, and
wherein the pillars include at least a third pillar of which the width increases as the distance from the vaporization portion increases and a fourth pillar of which the width decreases as the distance from the vaporization portion increases.
